# EUROPEAN PATENT SPECIFICATION

(11) **EP 4 631 108 B1**
(45) Date of publication and mention of the grant of the patent: **09.12.2026**
(21) Application number: 23836988.8
(22) Date of filing: 30.10.2023
(51) Int. Cl.: H02S 20/25, H10F 19/00

(54) **MODULAR PHOTOVOLTAIC ROOFING SYSTEM, METHOD FOR INSTALLING THEREOF AND SOLAR ROOF**
MODULARES FOTOVOLTAISCHES DACHSYSTEM, VERFAHREN ZUR INSTALLATION DAVON UND SOLARDACH
SYSTÈME DE TOITURE PHOTOVOLTAÏQUE MODULAIRE, SON PROCÉDÉ D'INSTALLATION ET TOIT SOLAIRE

(30) Priority: 13.01.2023 PL 44348723
(43) Date of publication of application: 15.10.2025
(73) Proprietor: BP2 Spolka Z Ograniczona Odpowiedzialnoscia, 30-302 Krakow (PL)
(72) Inventor: LACH, Mariusz, 22000 Sibenik (HR)
(74) Representative: AOMB Polska Sp. z.o.o.
(86) International application number: PCT/PL2023/050089
(87) International publication number: WO 2024/151173

(56) References cited:
- EP-A2- 2 533 300
- DE-A1- 19 521 098
- US-B1- 6 182 403
- US-B2- 10 505 492

## Description

### Technical field

The invention generally relates to the field of construction products used as roofing and photovoltaic solutions. More specifically, the subject-matter of the present invention isa modular photovoltaic roofing system composed of modular roof panels with an integrated photovoltaic cell configured for installation on a roof framework. The invention relates also to a method for installing said system on a roof framework and to a solar roof with the installed system.

### Background art

Polish patent application P.435257, filed by the Applicant of the present invention, discloses a modular roof panel comprising a body made of sheet metal and having a main plane comprising two transverse edges and two side edges, where the transverse edges have bends, one of which being bent downwards towards the lower surface, and the other being bent upwards towards the upper surface, where the lower and upper bends form a so-called flat lock seam formed by joining the respective transverse edges of adjacent roof panels during roof installation, wherein the body together with the male leg, the female leg, the upper bend and the lower bend constitutes a completely prefabricated machine-stamped component.

Traditional solar panels mounted on existing roof coverings for converting solar energy into electricity are also well known in the art. Such panels, however, disturb the original shape of the building and often protrude beyond its outline, which does not look attractive. Traditional solar panels also require the installation of an additional support structure and usually a skilled installation team, specializing in the installation of solar panels only, must be hired. Therefore, in practice, one team installs the roof covering while the other installs solar panels, which naturally translates into longer time and higher costs.

In view of the above, roof coverings with integrated photovoltaic cells have recently become more and more popular. Such products are attractive and appear virtually identical to a modular panel known in the art. Moreover, they can be installed on the roof by one installation team only that specializes in traditional roofing services.

In the current state of the art, only metal roofing tiles with built-in photovoltaic elements are known. For example, one can mention patent application No. P.433999, filed by the Applicant of the present invention. The above-mentioned application relates to a roofing element in the form of a modular metal roofing tile, where: a first layer of a higher temperature-activated polymer-based adhesive material is arranged on the upper surface; a photovoltaic element is located on the first layer of the adhesive material, the photovoltaic element being a passivated emitter and rear cell, fabricated in the PERC technology; a second layer of the higher temperature-activated polymer-based adhesive material is arranged on the photovoltaic element; a transparent protective layer is arranged on the second layer of the adhesive material; wherein the first layer of the adhesive material, the photovoltaic element, the second layer of the adhesive material, and the transparent protective layer are joined with each other and with the body of the roofing element in the lamination process.

At the same time, CN109831147A discloses a metal roofing tile comprising a base layer, a first adhesive layer, a photovoltaic cell layer, a second adhesive layer and a top layer.

KR20140141762A and US2019245478A1 in turn disclose the use of glass as a protective layer.

In a traditional photovoltaic system and in recently popular solar roof coverings, cable channels are arranged on the roof in an unorganized manner or attached with clamp bands, whereby they are exposed to unfavourable weather conditions and access by rodents, which poses a high risk of electric shock.

### Summary of the invention

The objective of the present invention is to provide a solution that will at least partially eliminate the disadvantages of the prior art.

According to a first aspect of the subject matter of the application, there is provided a modular photovoltaic roofing system comprising a plurality of modular roof panels made of sheet metal configured to form roof covering attached to a roof framework, wherein said at least one modular roof panel is integrated with a photovoltaic module arranged on an upper surface of said modular roof panel, said photovoltaic module is electrically insulated from the modular roof panel (40),
wherein said system further comprises:
an at least one longitudinal channel profile for routing electrical cables and/or mounting electronic devices, wherein the at least one longitudinal channel profile is configured to be disposed between horizontal members of the roof framework, which are spaced at certain intervals from each other parallel to a ridge of the roof,
an at least one longitudinal side profile for routing electrical cables and/or mounting electronic devices, wherein the at least one longitudinal side profile is configured to be disposed along a side edge of the roof framework extending perpendicular to the ridge of the roof.

In a preferred embodiment, the at least one modular roof panel equipped with a photovoltaic module has a through opening configured to receive an electrical junction box and to establish an electrical connection with conductive elements of the photovoltaic module.

In one embodiment, the photovoltaic module has protruding conductive elements forming a male connector configured to form an electrical connection with a complementary female connector of the electrical junction box.

It is preferred when the protruding conductive elements of the photovoltaic module pass through the through opening in the modular roof panel.

In one embodiment, the at least one longitudinal channel profile comprises a C-shaped body comprising a central wall forming the bottom, and two side walls.

In another practical embodiment, the side walls of the body of the longitudinal channel profile have mounting feet extending perpendicular to said side walls on the side of their outer surface, and wherein said mounting feet are configured to be connected to the adjacent horizontal members of the roof framework.

In yet another embodiment, the longer edges of the central wall of the body of the longitudinal channel profile, which central wall constitutes the bottom, run at an acute angle to each other.

In one embodiment, the at least one longitudinal side profile comprises an L-shaped body comprising a vertical wall and a horizontal wall.

In another embodiment, the L-shaped body of the at least one longitudinal side profile comprises an upper bend formed by bending the vertical wall at a right angle towards the outer surface of the vertical wall.

In yet another embodiment, the L-shaped body of the at least one longitudinal side profile comprises a lower bend formed by bending the horizontal wall at a right angle towards the lower surface of the horizontal wall.

According to the second aspect of the present application, there is provided a solar roof comprising a roof framework configured to transfer loads from a roof covering to a load-bearing walls of a building, comprising a plurality of horizontal members spaced apart from each other parallel to a ridge of a roof, where:
an at least one longitudinal channel profile for guiding electrical cables and/or mounting electronic devices is disposed between the adjacent horizontal members,
an at least one longitudinal side profile for routing electrical cables and/or mounting electronic devices is attached to a side edge of the roof framework, which side edge extends perpendicular to the ridge of the roof,
an at least one electrical junction box is electrically connected to a photovoltaic module,
a plurality of modular roof panels form the roof covering which is attached to the roof framework, thus covering the surface on which the horizontal members are arranged and the at least one longitudinal channel profile is placed between the adjacent horizontal members, where a through opening in the modular roof panel is aligned with a space constituting a tray for routing electrical cables, which tray is limited by walls of the at least one longitudinal channel profile,
said electrical junction box is placed in said through opening in the modular roof panel and suspended in said space constituting a tray of at least one longitudinal channel profile,
there is a gap between an edge defining said through opening in the modular roof panel and the entire circumference of the electrical junction box,
the electrical cables connecting the electrical junction box are arranged in said at least one longitudinal channel profile.

In an embodiment, an at least one power optimiser connected with the electrical cable to the electrical junction box is attached at the external side of the vertical wall of the at least one longitudinal side profile.

In one embodiment, the gap between the edge of the through opening and the electrical junction box is completely filled with an electrical insulating material. The electrical insulating material can be a resin or silicone.

In another embodiment, the solar roof comprises a modular barge flashing unit that is attached along the side edge of the roof framework and that entirely covers at least one longitudinal side profile.

In one embodiment, the roof framework includes a roofing support structure composed of vertical members extending perpendicular to the roof ridge and horizontal members arranged at certain intervals parallel to the roof ridge.

According to the third aspect of the subject matter of the application, there is provided a method for installing a modular photovoltaic roofing system according to the invention on a roof framework, comprising the following steps:
a. attaching an at least one longitudinal channel profile between two adjacent horizontal members of the roof framework, which are arranged at certain intervals from each other parallel to a ridge of a roof,
b. attaching an at least one longitudinal side profile to a side edge of the roof framework extending perpendicular to the ridge of the roof,
c. laying electrical cables are laid in the at least one longitudinal channel profile,
d. connecting an electrical junction box with the electric cables to the photovoltaic module to create a conductive connection,
e. arranging modular roof panels to form the roof covering, wherein the modular roof panels with an integrated photovoltaic module and the electrical junction box are arranged in such a way that the electrical junction box is suspended in a space constituting a tray of the at least one longitudinal channel profile.

In an embodiment, the method comprises the step of completely filling the gap between the edge of the through opening and the electrical junction box with an electrical insulating material, e.g. a resin or silicone.

### Advantageous effects of the invention

a modular photovoltaic roofing system forms a single system for use in a wide range of buildings, while performing the functions of a traditional roofing and solar panels. Due to the modular form, a quick and effective roofing installation is achieved. The modular roof panels create an eye-catching roof covering.

In the present invention, profiles for cable routing and installation of electrical or electronic devices are provided in organized places, and the structure of the profiles prevents the accumulation of condensate and makes access by pests much more difficult or even impossible.

A solar roof based on the system of the invention is constructed in a way that ensures full antishock protection of photovoltaic installations. In order to equalize the electrical potential, the panels on which the cells are installed are connected to the sheet metal flashings. The entire sheet metal part is connected to each other, thus forming a support structure connected to the lightning protection system.

### Brief description of the Drawings

The invention will be illustrated in an embodiment in the attached drawings, in which:
- Fig. 1: shows a roofing support structure with arranged longitudinal profiles.
- Fig. 2: shows a longitudinal channel profile in a perspective view.
- Fig. 3: shows a longitudinal side profile in a perspective view.

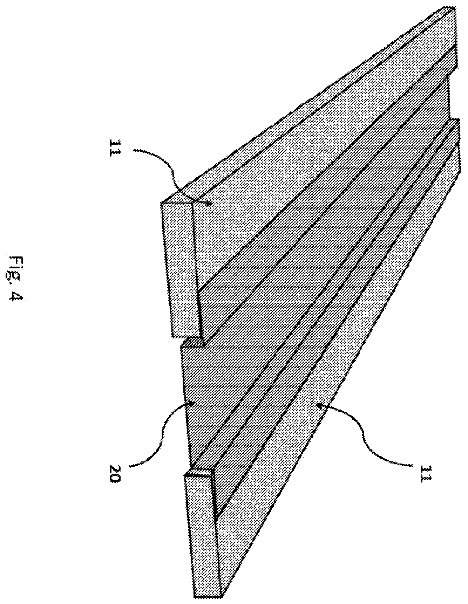

- Fig. 4: shows a longitudinal side profile placed between horizontal members of the roofing support structure.
- Fig. 5: shows a modular roof panel with an electrical junction box placed in a through opening.

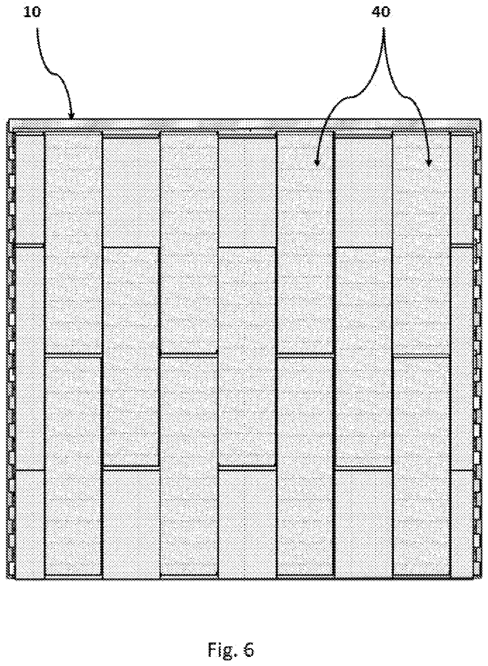

- Fig. 6: shows a roofing support structure with modular roof panels with photovoltaic cells arranged on it.

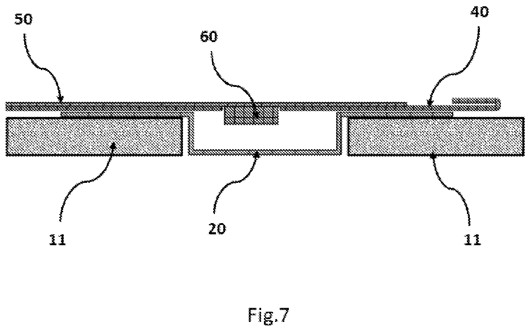

- Fig. 7: shows a partial cross-sectional view of a modular roof panel with a photovoltaic module.
- Fig. 8: shows a partial cross-sectional view of a solar roof through a modular roof panel with a photovoltaic module, an electrical junction box, a longitudinal channel profile and two horizontal members of the roofing support structure.
- Fig. 9: shows a partial view of a modular roof panel with a photovoltaic module and an electrical junction box in the assembled state.
- Fig. 10: shows a method for routing electrical cables.
- Fig. 11: shows the electrical connection diagram in more detail.
- Fig. 12: shows a view of a fragment of a solar roof showing a modular barge flashing unit with a partially exposed longitudinal side profile.
- Fig. 13: shows a fragment of the solar roof with a partially exposed longitudinal side profile showing a power optimiser and the method for routing electrical cables.

### Detailed description of a preferred embodiment

A modular photovoltaic roofing system according to a preferred embodiment is designed for installation on a roof framework. The purpose of the roof framework is to transfer loads from the roof covering to the load-bearing walls of the building. Typically, especially for pitched roofs, the roof framework is in the form of a wooden frame, which is called a roof truss. In residential houses, it is in particular the roof truss which is covered with an insulation layer, for example in the form of mats or foil protecting against adverse weather conditions such as rain, snow, wind or moisture. The proper roofing support structure is then placed on the insulation layer and attached to the roof truss. The roof panels are directly attached to this support structure. The support structure is usually in the form of a frame composed of vertical members called counter battens, which are arranged perpendicular to a ridge of the roof and horizontal members attached to the counter battens, called battens, which are arranged at regular intervals parallel to the ridge along the entire length of the counter battens.

The present invention will be presented in an embodiment, wherein the roofing is installed on a roofing support structure composed of such horizontal and vertical members, i.e. battens and counter-battens. Nonetheless, it will be obvious to one skilled in the art that the roof covering of the present invention can be installed on any other roof framework. It is therefore possible to install the roof covering directly on the roof truss or any other roof framework, which will contain horizontal members that will be used to attach longitudinal channel profiles. In particular, the roofing system according to the invention can be successfully installed on a roof framework without insulation and an additional roofing support structure.

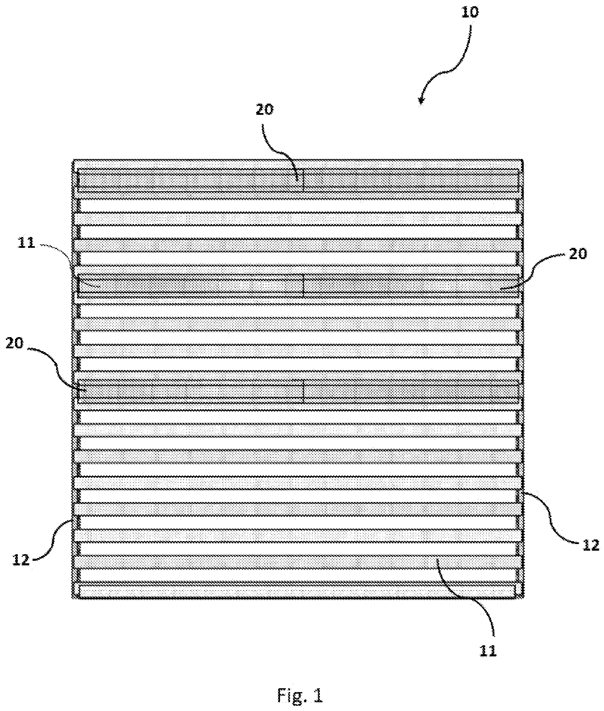

An example of such a roofing support structure 10 is shown in Fig. 1. As already mentioned above, it comprises vertical members 12 called counter battens and horizontal members 11 called battens. The vertical members 12 are arranged in a vertical plane perpendicular to the roof ridge, while the horizontal members 11 are arranged at certain intervals from each other, here in regular ones, parallel to each other and parallel to the roof ridge along the entire length of the vertical members 12.

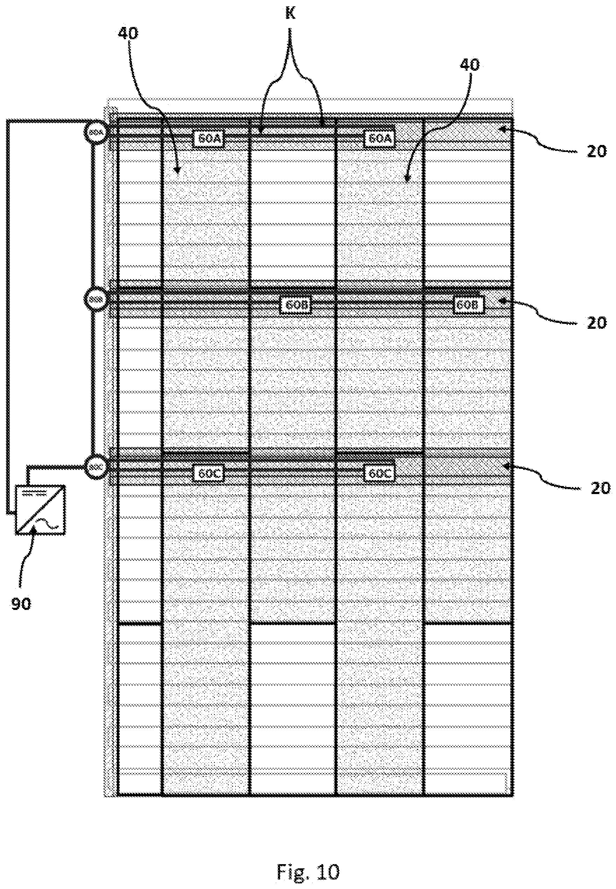

Between the horizontal members 11, longitudinal channel profiles 20 are arranged, which are used to route electrical cables K and for installation of electronic devices. Depending on the needs and the surface of the roof, an appropriate number of longitudinal channel profiles 20 are installed. Typically, there are two to six profiles, but there may be fewer or more of them. The longitudinal channel profiles 20 are also installed every few horizontal members 11, for example every three, four or five. There is thus no need for the longitudinal channel profiles 20 to be arranged between all horizontal members 11, which results from the arrangement of the modular roof panels 40. This is well illustrated by, for example, Fig. 10.

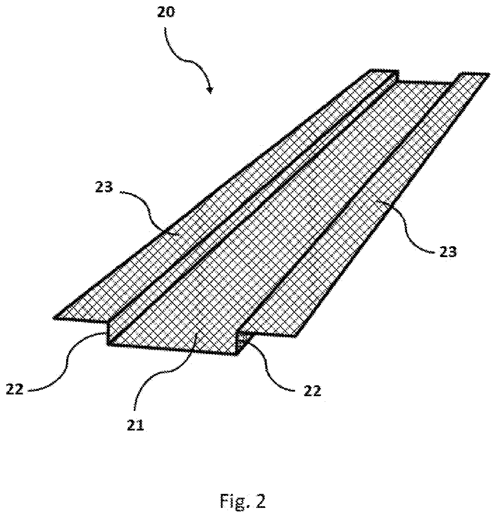

A preferred embodiment of the longitudinal channel profile 20 is shown in Fig. 2. In this embodiment, the longitudinal channel profile 20 is made of metal sheet by bending. The preferred material is steel or aluminium. The body of the longitudinal channel profile 20 is C-shaped in cross-section and comprises a central wall 21 constituting the bottom and two side walls 22 arranged perpendicular to the central wall 21.The space delimited by the central wall 21 and two side walls 22 forms a tray in which the electrical cables K are laid. Preferably, both side walls 22 have a mounting foot 23 which is connected to the upper edge of the side wall 22 at a right angle to its outer surface. Such mounting feet 23 can be easily made by appropriately bending outward portions of the side walls 22 on a press brake. The mounting feet 23 are used to attach the longitudinal channel profile 20 to the adjacent horizontal members 11. The longitudinal channel profile 20 is supported with the mounting feet 23 on the upper surfaces of the horizontal members 11. Additionally, the mounting feet 23 can be attached to these horizontal members 11 with screws or nails. It is also preferable for the central wall 21, i.e. the bottom of the tray, to be flush with the lower surface of the horizontal members 11. Ideally, the space forming the tray is contained between the two planes defined by the upper and lower surfaces of the horizontal members 11. The longitudinal channel profiles 20 may also have other shapes than that of the embodiment, as long as they are capable of routing cables in a longitudinal recess resembling a tray or channel.

In a preferred embodiment, the longer edges of the central wall 21 of the body of the longitudinal channel profile 2 extend at an acute angle to each other, so that the width of the bottom gradually increases or decreases in one direction. This results in a channel inclination that facilitates the gravitational drainage of condensate that may accumulate in the longitudinal channel profile 20 outside the roof structure.

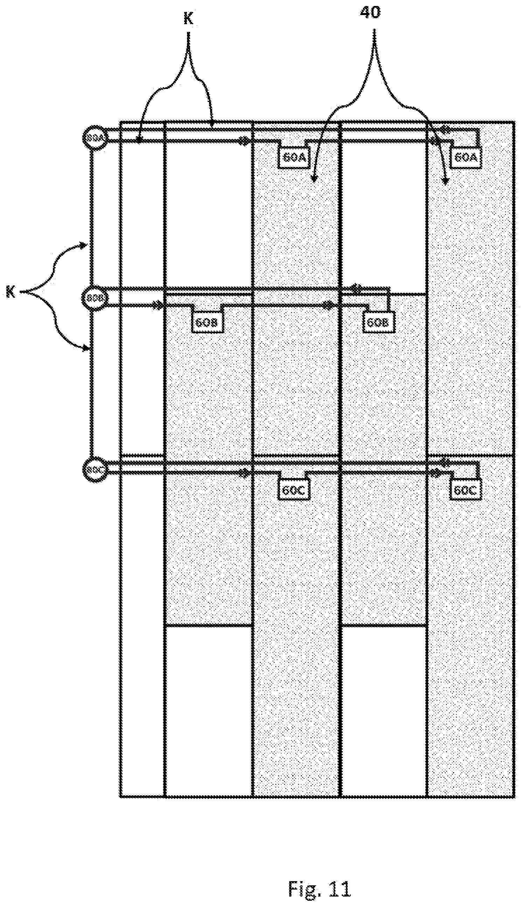

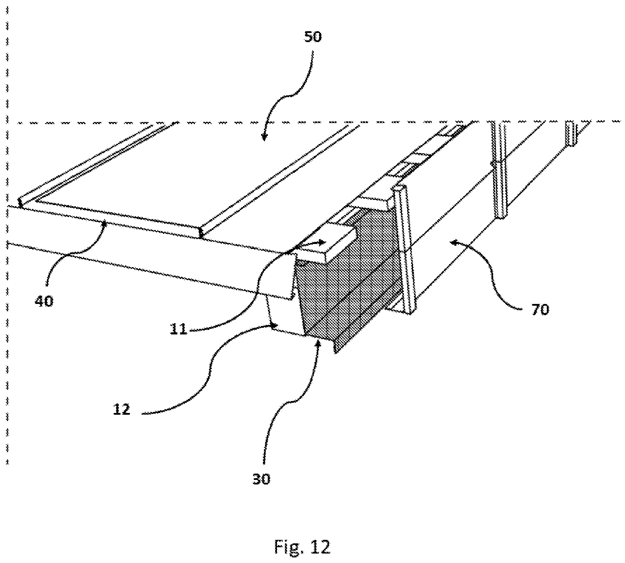

Another element of the modular photovoltaic roofing system presented in this embodiment is the longitudinal side profile 30. It is used for installation of electronic devices, for example power optimisers 80, which are shown schematically in Figs. 10 and 11, and for routing electrical cables K, for example those that connect the power optimisers 80 with each other. It also has a protective function - it ensures fire safety and limits access to rodents that could, for example, bite electrical cables K, thus leading to system failure. The longitudinal side profile 30 is attached to the side edge of the roof, for example to the extreme rafter, side board or the vertical member 12 of the roofing support structure 11 - the latter example is shown in Fig. 12.

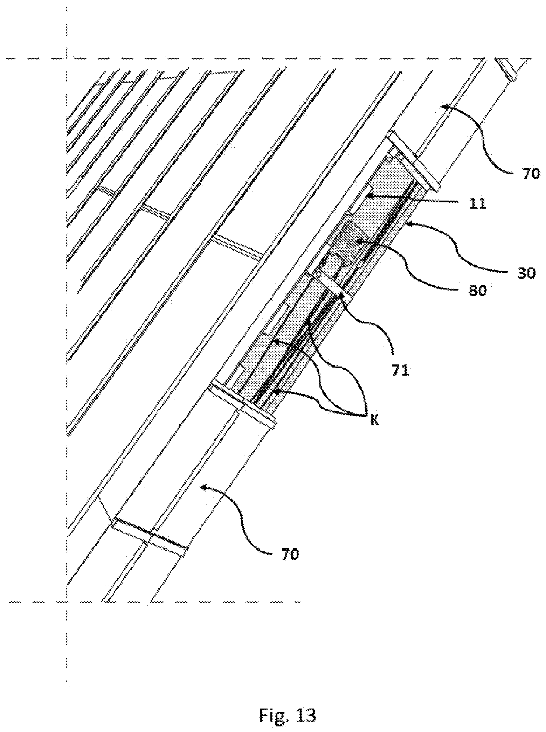

In a preferred embodiment, the longitudinal side profile 30 has a body with L-shaped cross-section. It is made of sheet metal, for example aluminium or steel, by bending. The body comprises a vertical wall 31, which is attached to the side edge of the roof, for example to the above-mentioned extreme rafter, side board or horizontal member 12 (counter batten), using fasteners such as screws or nails. The vertical wall 31 is connected by the horizontal wall 32. Preferably, the body also includes flashing elements such as bends and folds that allow for an aesthetic finishing of the roof covering, for example using the modular barge flashing unit 70, which is shown in Figs. 12 and 13 and will be described in more detail below. These preferred flashing elements include, for example, the upper bend 33 and the lower bend 34, which serve to connect to the modular barge flashing unit 70. The upper bend 33 is formed by bending the vertical wall 31 at a right angle towards its outer surface. The lower bend 34 is formed by bending the horizontal wall 32 at a right angle towards the bottom surface of the horizontal wall. Additionally, the lower bend 34 has a fold 35 extending parallel to and on the inner side of the lower bend 34.

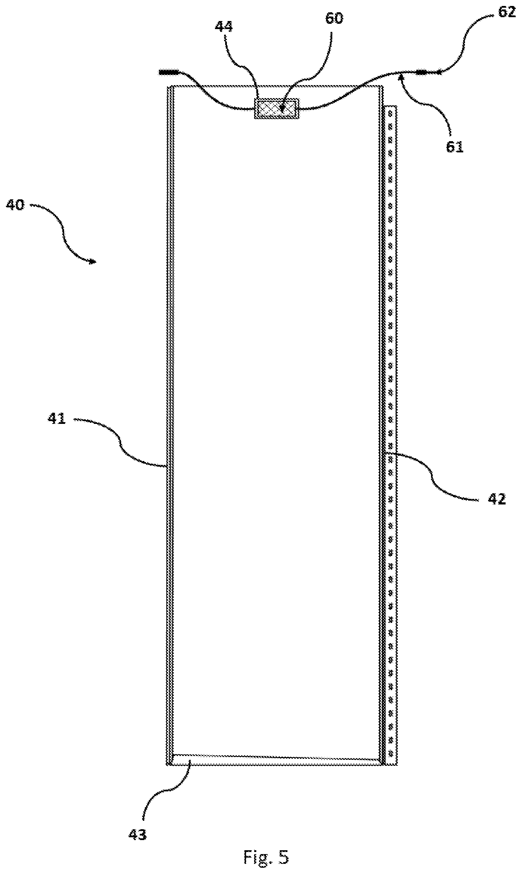

The modular photovoltaic roofing system further comprises a plurality of modular roof panels 40 that constitute a roof covering installed on the roofing support structure 10. These are rectangular panels known in the art, made of sheet metal, for example steel or other metals or metal alloys such as aluminium, copper or zinc. Preferably, roof panels are used that are disclosed in the Polish patent application No. P.435257, filed by the Applicant, the entire content of which is hereby incorporated into this specification. A modular roof panel such as disclosed in P.435257 is also shown in Fig. 5. Thus, a modular roof panel 40 according to a preferred embodiment comprises a rectangular sheet metal body having an upper surface, a lower surface, two transverse edges, i.e. an upper edge and lower edge and two side edges, i.e. left edge and right edge. One side edge is shaped into a male leg 42, and the other side edge is shaped into a female leg 41. Together they form a so-called snap lock seam formed by joining the corresponding side edges of adjacent roof panels. The transverse edges in turn have bends 43, i.e. an upper bend and a lower bend, one of which is bent downwards towards the lower surface, and the other is bent upwards towards the upper surface. The lower and upper bends form a so-called flat lock seam formed by joining the corresponding transverse edges of adjacent roof panels when installing the roof. In such a modular roof panel as described in P.435257, an additional opening 44 is made to receive an electrical junction box 60 and a photovoltaic module 50 is attached to it. The opening 44 is rectangular in shape and its dimensions are larger than the circumferential dimensions of the electric junction box 60, so that the electrical junction box 60 can be freely inserted therein. It will be obvious to one skilled in the art that other shapes are also conceivable. On the upper surface of the modular roof panel 40, there is a photovoltaic module 50 which connects to the modular roof panel.

The photovoltaic module 50 is electrically isolated from the modular roof panel 40. Preferably, it is permanently integrated with the modular roof panel 40 in a lamination process.

Preferably, a photovoltaic module 50 is used, comprising successively:
a layer of elevated temperature-activated adhesive material, preferably based on poly(ethylene-co-vinyl acetate) - ethylene-vinyl acetate copolymer (EVA) or polyolefin elastomers (POE), where the first the layer adheres to the upper surface of the modular roof panel 40;
a layer of composite insulating material (backsheet), preferably based on poly(ethylene terephthalate), UV-resistant and crosslinkable at elevated temperature;
a layer of elevated temperature-activated adhesive material, preferably based on poly(ethylene-co-vinyl acetate) - ethylene-vinyl acetate copolymer (EVA) or polyolefin elastomers (POE);
a generator unit consisting of a plurality of photovoltaic elements connected by means of a copper-silver tape in the soldering process so as to form an open electrical circuit, the ends of which are permanently attached to electrical junction boxes 60 with electrical cables 61 terminated with electrical connectors 62, preferably complying with the MC4 standard (J-Box), wherein a photovoltaic element is a passivated emitter and rear cell fabricated using PERC technology;
a layer of adhesive material, based on poly(ethylene-co-vinyl acetate) - ethylene-vinyl acetate copolymer (EVA) or polyolefin elastomers (POE), activated at elevated temperature;
a transparent protective layer consisting of a glass pane with a low iron content, the coating of which is made in a way that limits the reflection of sunlight.

The photovoltaic module 50 has protruding conductive elements forming a male connector 51, configured to form an electrical connection with a complementary female connector 63 of the electrical junction box 60. The protruding conductive elements may, for example, be in the form of electrical contacts or current buses which come into contact with the corresponding conductive elements of the female connector 63 in the electrical junction box 60. The protruding conductive elements pass through the opening 44 in the modular roof panel 40 and protrude below its lower surface.

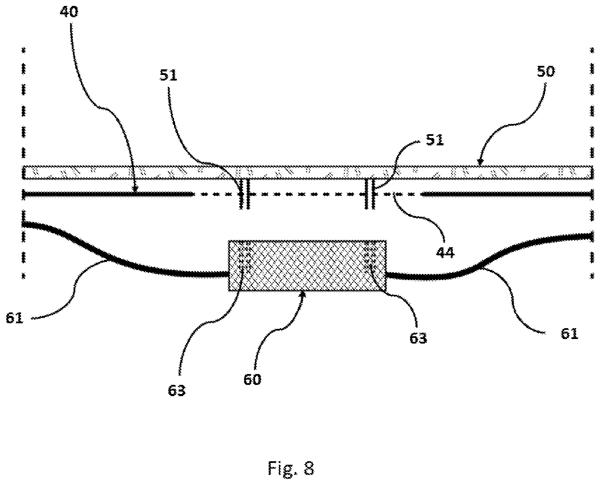

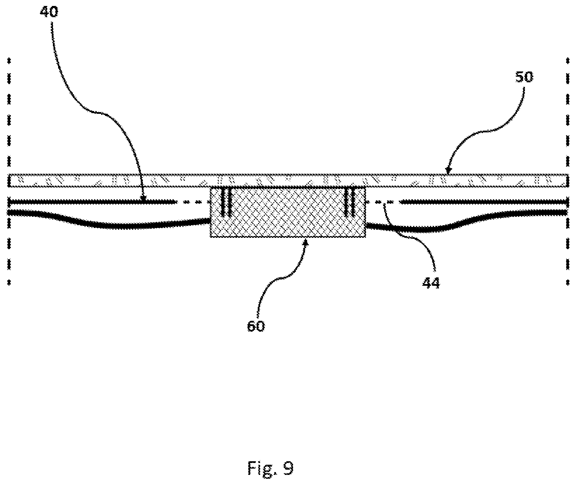

The connection between the photovoltaic module 50 and the electrical junction box 60 is schematically illustrated in Figs. 8 and 9, where Fig. 8 is a view before connection and Fig. 9 is a view after connection. The electrical junction box 60 is located in an opening 44 in the modular roof panel 40, as can be clearly seen in Fig. 5 and 9. As already mentioned above, the male connector 51 is electrically coupled to the female connector 63 so that it is possible to receive current and send it to the network.

The electrical junction box 60 is arranged in the opening 44 such that there is a gap between the edge of the opening 44 and the entire circumference of the electrical junction box 60. This means that the electrical junction box 60 does not touch the edge of the opening 44 at any point and therefore does not come into contact with the metal body of the modular roof panel 40. Due to the risk of electric shock and the ingress of water or rodents, the gap is filled with an electrical insulating material , for example resin or silicone.

Additionally, the electrical junction box 60 is suspended in the space constituting the tray of the longitudinal channel profile 20, so that there is also no contact with the metal body of the longitudinal channel profile 20. This is well illustrated in Fig. 5, where it is clearly visible that the electrical junction box has no contact with metal elements, which are known to conduct electricity. This positioning of the electrical junction box 60 also prevents water and rodents from entering.

The method for routing electrical cables K and the electrical connection diagram of the solar roof are illustrated in Fig. 10 and 11. In this embodiment, the solar roof comprises three longitudinal channel profiles 20 in which electrical cables K are routed. As already mentioned earlier, this results from the arrangement of modular roof panels 40 with photovoltaic modules 50 and the fact that the photovoltaic modules 50 are connected to each other in pairs. The modular roof panels 40 comprising integrated photovoltaic modules 50 are indicated by hatching, and those with no hatching are typical roof panels. As can be seen in the figures discussed here, the electrical junction boxes 60 of the modular roof panels 40 in a given pair are connected by electrical cables K to each other and to the power optimiser 80, forming series circuits. In this embodiment, these are three series circuits marked with the letters A, B, C added to the numerical designations appropriate to the electrical junction boxes 60 and the power optimisers 80. Further, the individual power optimisers marked 80A, 80B and 80C are then connected by electrical cables K in series with the converter 90, in this embodiment in the form of a photovoltaic inverter.

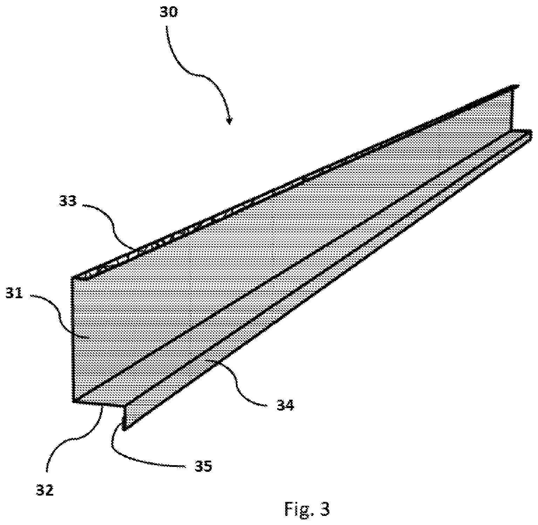

As already mentioned above, one preferred embodiment of the invention, which provides for the use of a modular barge flashing unit 70, will be discussed now with reference to Figs. 12 and 13. Fig. 12 shows a partial view of a roof with a roof covering made of modular roof panels 40 with an integrated photovoltaic module 50, which roof covering has been installed on a roof covering support structure 11 as described above and shown in Fig. 1. As can be also seen in Fig. 12, along the side edge of the roof, a longitudinal side profile 30, shown and described above with reference to Fig. 3, is attached to the vertical member 12 of the roof covering support structure 10. Fig. 13 shows a fragment of the solar roof with removed modules of the modular barge flashing unit in the area where the power optimiser 80 is fastened. As can be seen in this Figure, the power optimiser 80 is attached to the vertical wall 31 of the longitudinal side profile 30. Electric cables K are routed along this longitudinal side profile, for example those which connect all the power optimisers 80 among themselves and which are further connected to a converter 90, for example having the form of a photovoltaic inverter converting direct current into alternating current, which is in the electrical socket. For better attachment of the modular barge flashing unit 70, mounting brackets 71 are preferably used, for example in the form of angle brackets, which are screwed to the longitudinal side profile 30.

Preferably, a modular barge flashing unit 70 is used such as the one disclosed in the Polish patent application No. P.442748 filed by Applicant, the entire content of which is hereby incorporated into the specification of the present patent application. Such a modular barge flashing unit disclosed in P.442748 is shown in this embodiment and illustrated in Figs. 12 and 13. The use of the modular barge flashing unit according to P.442748 provides for a quick and easy access to power optimisers 80 or other electrical or electronic devices arranged in the longitudinal side profile 30, which is clearly shown in Fig. 13. For maintenance purposes, it is not necessary to dismantle the entire roof, only a specific barge flashing unit is removed to gain access to a given power optimiser 80. Attaching electrical and electronic devices, such as power optimisers 80, to the longitudinal side profile 30 and using a modular barge flashing unit not only facilitates maintenance work, but ensures fire safety and limits access by pests.

The modular barge flashing unit 70 also encloses completely the longitudinal side profile 30, ensuring an aesthetic finishing.

Method for installing a modular photovoltaic roofing system according to the invention comprises the following steps:
a. at least one longitudinal channel profile 20 is attached between two adjacent horizontal members 11 of the roof framework, which are arranged at certain intervals from each other parallel to the roof ridge,
b. at least one longitudinal side profile 30 is attached to the side edge of the roof framework extending perpendicular to the roof ridge,
c. electrical cables are laid in at least one longitudinal channel profile 20,
d. an electrical junction box 60 with electrical cables 61 is connected to the photovoltaic module 50 to obtain a conductive connection,
e. modular roof panels 40 are arranged to form roof covering, wherein the modular roof panels 40 with an integrated photovoltaic module 50 and an electrical junction box 60 are arranged in such a way that the electrical junction box 60 is suspended in the space constituting the tray of at least one longitudinal channel profile 20.

The method of arranging the modular roof panels in step e) may be consistent with that described in the above-mentioned patent application No. P.435257.

## Claims

1. A modular photovoltaic roofing system comprising a plurality of modular roof panels (40) made of sheet metal configured to form a roof covering attached to a roof framework, wherein said at least one modular roof panel (40) is integrated with a photovoltaic module (50) arranged on an upper surface of said modular roof panel (40), said photovoltaic module is electrically insulated from the modular roof panel (40),
**characterised in that** the system further comprises:
an at least one longitudinal channel profile (20) for routing electrical cables (K) and/or mounting electronic devices, wherein the at least one longitudinal channel profile (20) is configured to be disposed between horizontal members (11) of the roof framework, which are spaced at certain intervals from each other parallel to a ridge of the roof,
an at least one longitudinal side profile (30) for routing electrical cables (K) and/or mounting electronic devices, wherein the at least one longitudinal side profile (30) is configured to be disposed along a side edge of the roof framework extending perpendicular to the ridge of the roof.

2. The modular system according to claim 1, **wherein** the at least one modular roof panel (40) equipped with a photovoltaic module (50) has a through opening (44) configured to receive an electrical junction box (60) and to establish an electrical connection with conductive elements of the photovoltaic module (60).

3. The modular system according to claim 1 or 2, **wherein** the photovoltaic module (50) has protruding conductive elements forming a male connector (51) configured to form an electrical connection with a complementary female connector (63) of the electrical junction box (60).

4. The modular system according to claim 3, **wherein** the protruding conductive elements of the photovoltaic module (60) pass through the through opening (44) in the modular roof panel (40).

5. The modular system according to claim 1, **wherein** the at least one longitudinal channel profile (20) comprises a C-shaped body comprising a central wall (21) forming the bottom and two side walls (22).

6. The modular system according to claim 5, **wherein** the side walls (22) of the body of the longitudinal channel profile (20) have mounting feet (23) extending perpendicular to said side walls (22) on the side of their outer surface, wherein said mounting feet (23) are configured to be connected to the adjacent horizontal members (11) of the roof framework.

7. The modular system according to claim 5 or 6, **wherein** longer edges of the central wall (21) of the body of the longitudinal channel profile (20), which central wall (21) constitutes the bottom, run at an acute angle to each other.

8. The modular system according to claim 1, **wherein** the at least one longitudinal side profile (30) comprises an L-shaped body comprising a vertical wall (31) and a horizontal wall (32).

9. The modular system according to claim 8, **wherein** the L-shaped body of the least one longitudinal side profile (30) comprises an upper bend (33) formed by bending the vertical wall (31) at a right angle towards the outer surface of the vertical wall (31).

10. The modular system according to claim 8 or 9, **wherein** the L-shaped body of the least one longitudinal side profile (30) comprises a lower bend (34) formed by bending the horizontal wall (32) at a right angle towards the lower surface of the horizontal wall (34).

11. A solar roof comprising a roof framework configured to transfer loads from a roof covering to a load-bearing walls of a building, comprising a plurality of horizontal members (11) spaced apart from each other parallel to a ridge of a roof, **characterised in that** said solar roof comprises a modular photovoltaic roofing system as defined in any of claims 1-10,
wherein an at least one longitudinal channel profile (20) for routing electrical cables (K) or mounting electronic devices is disposed between the adjacent horizontal members (11),
wherein an at least one longitudinal side profile (30) for routing electrical cables and/or mounting electronic devices is attached to a side edge of the roof framework, which side edge extends perpendicular to the ridge of the roof,
wherein an at least one electrical junction box (60) is electrically connected to a photovoltaic module (50),
wherein a plurality of modular roof panels (40) form the roof covering that is attached to the roof framework, thus covering the surface on which the horizontal members (11) are arranged and the at least one longitudinal channel profile (20) is placed between the adjacent horizontal members (11), where a through opening (44) in the modular roof panel (40) is aligned with a space constituting a tray for routing electrical cables (K), said tray being limited by walls of the at least one longitudinal channel profile (20),
wherein said electrical junction box (60) is placed in said through opening (44) in the modular roof panel (40) and suspended in the space constituting the tray of the at least one longitudinal channel profile (20),
wherein there is a gap between an edge defining said through opening (44) in the modular roof panel (40) and the entire circumference of the electrical junction box (60),
wherein the electrical cables (K) connecting the electrical junction box (60) are arranged in said at least one longitudinal channel profile (20).

12. The solar roof according to claim 11, **wherein** an at least one power optimiser (80) connected with the electrical cable (K) to the electrical junction box (60) is attached at the external side of the vertical wall (31) of the at least one longitudinal side profile (30).

13. The solar roof according to claim 11, **wherein** the gap between the edge of the through opening (44) and the electrical junction box (60) is completely filled with an electrical insulating material.

14. The solar roof according to claim 11, **wherein** the electrical insulating material is a resin or silicone.

15. The solar roof according to claim 11, **wherein** it comprises a modular barge flashing unit (70) that is attached along the side edge of the roof framework and that entirely covers the at least one longitudinal side profile (30).

16. The solar roof according to claim 11, **wherein** the roof framework includes a roofing support structure (10) composed of vertical members (12) extending perpendicular to the ridge of the roof and horizontal members (11) arranged at certain intervals parallel to the ridge of the roof.

17. A method for installing a modular photovoltaic roofing system as defined in any claim 1-10 on a roof framework, **characterised in that** said method comprises the following steps:
a. attaching an at least one longitudinal channel profile (20) between two adjacent horizontal members (11) of the roof framework, which are arranged at certain intervals from each other parallel to a ridge of a roof,
b. attaching an at least one longitudinal side profile (30) to a side edge of the roof framework extending perpendicular to the ridge of the roof,
c. laying electrical cables in the at least one longitudinal channel profile (20),
d. connecting an electrical junction box (60) with the electrical cables (61) to the photovoltaic module (50) to create a conductive connection,
e. arranging modular roof panels (40) to form the roof covering, wherein the modular roof panels (40) with the integrated photovoltaic module (50) and the electrical junction box (60) are arranged in such a way that the electrical junction box (60) is suspended in a space constituting a tray of the at least one longitudinal channel profile (20).

18. The method according to claim 11, **wherein** it comprises the step of completely filling the gap between the edge of the through opening (44) and the electrical junction box (60) with an electrical insulating material.

## Patentansprüche

1. Modulares fotovoltaisches Dachsystem, umfassend eine Vielzahl modularer Dachpaneele (40) aus Blech, die dazu ausgebildet sind, eine an einem Dachtragwerk befestigte Dacheindeckung zu bilden, **wobei** das mindestens eine modulare Dachpaneel (40) mit einem Fotovoltaikmodul (50) integriert ist, das auf einer Oberseite des modularen Dachpaneels (40) platziert ist, wobei das Fotovoltaikmodul elektrisch von dem modularen Dachpaneel (40) isoliert ist,
**dadurch gekennzeichnet, dass** das System ferner Folgendes umfasst:
mindestens ein Längsrinnenprofil (20) zur Führung elektrischer Kabel (K) und/oder zur Montage elektronischer Vorrichtungen, **wobei** das mindestens eine Längsrinnenprofil (20) dazu ausgebildet ist, zwischen horizontalen Elementen (11) des Dachtragwerks platziert zu werden, die in bestimmten Abständen voneinander parallel zu einem Dachfirst angeordnet sind,
mindestens ein Längsseitenprofil (30) zur Führung elektrischer Kabel (K) und/oder zur Montage elektronischer Vorrichtungen, **wobei** das mindestens eine Längsseitenprofil (30) dazu ausgebildet ist, entlang einer Seitenkante des Dachtragwerks platziert zu werden, die sich senkrecht zum Dachfirst erstreckt.

2. Modulares System nach Anspruch 1, **wobei** das mindestens eine mit einem Fotovoltaikmodul (50) ausgestattete modulare Dachpaneel (40) eine Durchgangsöffnung (44) aufweist, die dazu ausgebildet ist, eine elektrische Anschlussdose (60) aufzunehmen und eine elektrische Verbindung mit leitfähigen Elementen des Fotovoltaikmoduls (60) herzustellen.

3. Modulares System nach Anspruch 1 oder 2, **wobei** das Fotovoltaikmodul (50) vorstehende leitfähige Elemente aufweist, die einen Stecker (51) bilden, der dazu ausgebildet ist, eine elektrische Verbindung mit einer komplementären Buchse (63) der elektrischen Anschlussdose (60) herzustellen.

4. Modulares System nach Anspruch 3, **wobei** die vorstehenden leitfähigen Elemente des Fotovoltaikmoduls (60) durch die Durchgangsöffnung (44) im modularen Dachpaneel (40) hindurchtreten.

5. Modulares System nach Anspruch 1, **wobei** das mindestens eine Längsrinnenprofil (20) einen C-förmigen Körper umfasst, der eine den Boden bildende Mittelwand (21) und zwei Seitenwände (22) umfasst.

6. Modulares System nach Anspruch 5, **wobei** die Seitenwände (22) des Körpers des Längsrinnenprofils (20) Befestigungsfüße (23) aufweisen, die sich auf der Seite ihrer Außenfläche senkrecht zu den Seitenwänden (22) erstrecken, **wobei** die Befestigungsfüße (23) dazu ausgebildet sind, mit den benachbarten horizontalen Elementen (11) des Dachtragwerks verbunden zu werden.

7. Modulares System nach Anspruch 5 oder 6, **wobei** die längeren Kanten der Mittelwand (21) des Körpers des Längsrinnenprofils (20), dessen Mittelwand (21) den Boden bildet, in einem spitzen Winkel zueinander verlaufen.

8. Modulares System nach Anspruch 1, **wobei** das mindestens eine Längsseitenprofil (30) einen L-förmigen Körper umfasst, der eine vertikale Wand (31) und eine horizontale Wand (32) umfasst.

9. Modulares System nach Anspruch 8, **wobei** der L-förmige Körper des mindestens einen Längsseitenprofils (30) eine obere Abkantung (33) umfasst, die durch Abkanten der vertikalen Wand (31) im rechten Winkel zur Außenfläche der vertikalen Wand (31) gebildet wird.

10. Modulares System nach Anspruch 8 oder 9, **wobei** der L-förmige Körper des mindestens einen Längsseitenprofils (30) eine untere Abkantung (34) umfasst, die durch Abkanten der horizontalen Wand (32) im rechten Winkel zur Unterseite der horizontalen Wand (34) gebildet wird.

11. Solardach, umfassend ein Dachtragwerk, das dazu ausgebildet ist, Lasten von einer Dacheindeckung auf tragende Wände eines Gebäudes zu übertragen, umfassend eine Vielzahl von horizontalen Elementen (11), die parallel zu einem Dachfirst voneinander beabstandet sind, **dadurch gekennzeichnet, dass** das Solardach ein modulares fotovoltaisches Dachsystem nach einem der Ansprüche 1-10 umfasst,
wobei mindestens ein Längsrinnenprofil (20) zur Führung elektrischer Kabel (K) und/oder zur Montage elektronischer Vorrichtungen zwischen den benachbarten horizontalen Elementen (11) platziert ist,
wobei mindestens ein Längsseitenprofil (30) zur Führung elektrischer Kabel und/oder zur Montage elektronischer Vorrichtungen an einer Seitenkante des Dachtragwerks befestigt ist, dessen Seitenkante sich senkrecht zum Dachfirst erstreckt,
wobei mindestens eine elektrische Anschlussdose (60) elektrisch mit einem Fotovoltaikmodul (50) verbunden ist,
wobei eine Vielzahl modularer Dachpaneele (40) die Dacheindeckung bildet, die am Dachtragwerk befestigt ist und somit die Fläche abdeckt, auf der die horizontalen Elemente (11) angeordnet sind, und das mindestens eine Längsrinnenprofil (20) zwischen den benachbarten horizontalen Elementen (11) platziert ist, wobei eine Durchgangsöffnung (44) im modularen Dachpaneel (40) mit einem Raum fluchtet, der eine Rinne zur Verlegung elektrischer Kabel (K) bildet, wobei diese Rinne durch die Wände des mindestens einen Längsrinnenprofils (20) begrenzt ist,
wobei die elektrische Anschlussdose (60) in der Durchgangsöffnung (44) im modularen Dachpaneel (40) platziert und in dem Raum aufgehängt ist, der die Rinne des mindestens einen Längsrinnenprofils (20) bildet,
wobei zwischen einem Rand, der die Durchgangsöffnung (44) im modularen Dachpaneel (40) festlegt, und dem gesamten Umfang der elektrischen Anschlussdose (60) ein Spalt vorhanden ist,
wobei die mit der elektrischen Anschlussdose (60) verbundenen elektrischen Kabel (K) in dem mindestens einen Längsrinnenprofil (20) angeordnet sind.

12. Solardach nach Anspruch 11, **wobei** mindestens ein Leistungsoptimierer (80), der über das elektrische Kabel (K) mit der elektrischen Anschlussdose (60) verbunden ist, an der Außenseite der vertikalen Wand (31) des mindestens einen Längsseitenprofils (30) befestigt ist.

13. Solardach nach Anspruch 11, **wobei** der Spalt zwischen dem Rand der Durchgangsöffnung (44) und der elektrischen Anschlussdose (60) vollständig mit einem elektrisch isolierenden Material ausgefüllt ist.

14. Solardach nach Anspruch 11, **wobei** das elektrisch isolierende Material ein Harz oder Silikon ist.

15. Solardach nach Anspruch 11, **wobei** es eine modulare Ortgangblech-Baugruppe (70) umfasst, die entlang der Seitenkante des Dachtragwerks befestigt ist und das mindestens eine Längsseitenprofil (30) vollständig abdeckt.

16. Solardach nach Anspruch 11, **wobei** das Dachtragwerk eine Dachstützkonstruktion (10) einschließt, die aus vertikalen Elementen (12), die sich senkrecht zum Dachfirst erstrecken, und horizontalen Elementen (11) besteht, die in bestimmten Abständen parallel zum Dachfirst angeordnet sind.

17. Verfahren zur Installation eines modularen fotovoltaischen Dachsystems nach einem der Ansprüche 1-10 auf einem Dachtragwerk, **dadurch gekennzeichnet, dass** das Verfahren die folgenden Schritte umfasst:
a. Befestigen mindestens eines Längsrinnenprofils (20) zwischen zwei benachbarten horizontalen Elementen (11) des Dachtragwerks, die in bestimmten Abständen voneinander parallel zu einem Dachfirst angeordnet sind,
b. Befestigen mindestens eines Längsseitenprofils (30) an einer Seitenkante des Dachtragwerks, die sich senkrecht zum Dachfirst erstreckt,
c. Verlegen elektrischer Kabel in dem mindestens einen Längsrinnenprofil (20),
d. Verbinden einer elektrischen Anschlussdose (60) über die elektrischen Kabel (61) mit dem Fotovoltaikmodul (50), um eine leitfähige Verbindung herzustellen,
e. Verlegen modularer Dachpaneele (40) zur Bildung der Dacheindeckung, **wobei** die modularen Dachpaneele (40) mit dem integrierten Fotovoltaikmodul (50) und der elektrischen Anschlussdose (60) derart verlegt werden, dass die elektrische Anschlussdose (60) in einem Raum aufgehängt ist, der eine Rinne des mindestens einen Längsrinnenprofils (20) bildet.

18. Verfahren nach Anspruch 11, **wobei** es den Schritt umfasst, den Spalt zwischen dem Rand der Durchgangsöffnung (44) und der elektrischen Anschlussdose (60) vollständig mit einem elektrisch isolierenden Material auszufüllen.

## Revendications

1. Système de toiture photovoltaïque modulaire comprenant une pluralité de panneaux de toiture modulaires (40) en tôle, conçus pour former une couverture de toit fixée à une charpente du toit, **dans lequel** ledit au moins un panneau de toiture modulaire (40) intègre un module photovoltaïque (50) disposé sur une surface supérieure dudit panneau de toiture modulaire (40), ledit module photovoltaïque étant isolé électriquement du panneau de toiture modulaire (40),
**caractérisé en ce que** le système comprend en outre :
au moins un profilé longitudinal en forme de goulotte (20) destiné au cheminement de câbles électriques (K) et/ou au montage de dispositifs électroniques, **dans lequel** ledit au moins un profilé longitudinal en forme de goulotte (20) est conçu pour être disposé entre des éléments horizontaux (11) de la charpente du toit, qui sont espacés à certains intervalles les uns des autres, parallèlement au faîte du toit,
au moins un profilé latéral longitudinal (30) destiné au cheminement de câbles électriques (K) et/ou au montage de dispositifs électroniques, **dans lequel** ledit au moins un profilé latéral longitudinal (30) est conçu pour être disposé le long d'un bord latéral de la charpente du toit s'étendant perpendiculairement au faîte du toit.

2. Système modulaire selon la revendication 1, **dans lequel** le au moins un panneau de toiture modulaire (40) équipé d'un module photovoltaïque (50) comporte une ouverture traversante (44) conçue pour recevoir un boîtier de raccordement électrique (60) et pour établir une connexion électrique avec des éléments conducteurs du module photovoltaïque (60).

3. Système modulaire selon la revendication 1 ou 2, **dans lequel** le module photovoltaïque (50) comporte des éléments conducteurs saillants formant un connecteur mâle (51) conçu pour établir une connexion électrique avec un connecteur femelle complémentaire (63) du boîtier de raccordement électrique (60).

4. Système modulaire selon la revendication 3, **dans lequel** les éléments conducteurs saillants du module photovoltaïque (60) traversent l'ouverture traversante (44) du panneau de toiture modulaire (40).

5. Système modulaire selon la revendication 1, **dans lequel** le au moins un profilé longitudinal en forme de goulotte (20) comprend un corps en forme de C comprenant une paroi centrale (21) formant le fond et deux parois latérales (22).

6. Système modulaire selon la revendication 5, **dans lequel** les parois latérales (22) du corps du profilé longitudinal en forme de goulotte (20) comportent des pattes de fixation (23) s'étendant perpendiculairement auxdites parois latérales (22) sur le côté de leur surface extérieure, **dans lequel** lesdits pattes de fixation (23) sont conçues pour être reliés aux éléments horizontaux (11) adjacents de la charpente du toit.

7. Système modulaire selon la revendication 5 ou 6, **dans lequel** les bords les plus longs de la paroi centrale (21) du corps du profilé longitudinal en forme de goulotte (20), laquelle paroi centrale (21) constitue le fond, s'étendent l'un par rapport à l'autre selon un angle aigu.

8. Système modulaire selon la revendication 1, **dans lequel** le au moins un profilé latéral longitudinal (30) comprend un corps en forme de L comprenant une paroi verticale (31) et une paroi horizontale (32).

9. Système modulaire selon la revendication 8, **dans lequel** le corps en forme de L d'au moins un profilé latéral longitudinal (30) comprend un pli supérieur (33) formé par le pliage de la paroi verticale (31) à angle droit vers la surface extérieure de la paroi verticale (31).

10. Système modulaire selon la revendication 8 ou 9, **dans lequel** le corps en forme de L d'au moins un profilé latéral longitudinal (30) comprend un pli inférieur (34) formé par le pliage de la paroi horizontale (32) à angle droit vers la face inférieure de la paroi horizontale (34).

11. Toit solaire comprenant une charpente du toit conçue pour transférer les charges d'une couverture de toit aux murs porteurs d'un bâtiment, comprenant une pluralité d'éléments horizontaux (11) espacés les uns des autres parallèlement au faîte du toit, **caractérisé en ce que** ledit toit solaire comprend un système de toiture photovoltaïque modulaire tel que défini dans l'une quelconque des revendications 1 à 10,
dans lequel au moins un profilé longitudinal en forme de goulotte (20), destiné au cheminement de câbles électriques (K) ou au montage de dispositifs électroniques, est disposé entre les éléments horizontaux (11) adjacents,
dans lequel au moins un profilé latéral longitudinal (30), destiné au cheminement de câbles électriques et/ou au montage de dispositifs électroniques, est fixé à un bord latéral de la charpente du toit, lequel bord latéral s'étend perpendiculairement au faîte du toit,
dans lequel au moins un boîtier de raccordement électrique (60) est raccordé électriquement à un module photovoltaïque (50),
dans lequel une pluralité de panneaux de toiture modulaires (40) forme la couverture de toit fixée à la charpente du toit, recouvrant ainsi la surface sur laquelle sont disposés les éléments horizontaux (11), et le au moins un profilé longitudinal en forme de goulotte (20) est placé entre les éléments horizontaux (11) adjacents, une ouverture traversante (44) dans le panneau de toiture modulaire (40) étant alignée avec un espace constituant une goulotte destinée au cheminement de câbles électriques (K), ladite goulotte étant délimité par les parois du au moins un profilé longitudinal en forme de goulotte (20),
dans lequel ledit boîtier de raccordement électrique (60) est placé dans ladite ouverture traversante (44) du panneau de toiture modulaire (40) et suspendue dans l'espace constituant la goulotte dudit au moins un profilé longitudinal en forme de goulotte (20),
dans lequel il existe un jeu entre un bord définissant ladite ouverture traversante (44) du panneau de toiture modulaire (40) et l'ensemble du pourtour du boîtier de raccordement électrique (60),
dans lequel les câbles électriques (K) raccordés au boîtier de raccordement électrique (60) sont disposés dans ledit au moins un profilé longitudinal en forme de goulotte (20).

12. Toit solaire selon la revendication 11, **dans lequel** au moins un optimiseur de puissance (80), raccordé par le câble électrique (K) au boîtier de raccordement électrique (60), est fixé sur la face extérieure de la paroi verticale (31) d'au moins un profilé latéral longitudinal (30).

13. Toit solaire selon la revendication 11, **dans lequel** le jeu entre le bord de l'ouverture traversante (44) et le boîtier de raccordement électrique (60) est entièrement rempli d'un matériau électriquement isolant.

14. Toit solaire selon la revendication 11, **dans lequel** le matériau électriquement isolant est une résine ou du silicone.

15. Toit solaire selon la revendication 11, **dans lequel** il comprend un ensemble modulaire d'habillage de rive (70) qui est fixé le long du bord latéral de la charpente du toit et qui recouvre entièrement le au moins un profilé latéral longitudinal (30).

16. Toit solaire selon la revendication 11, **dans lequel** la charpente du toit comprend une structure de support de toiture (10) composée d'éléments verticaux (12) s'étendant perpendiculairement au faîte du toit et d'éléments horizontaux (11) disposés à certains intervalles parallèlement au faîte du toit.

17. Procédé d'installation d'un système de toiture photovoltaïque modulaire tel que défini dans l'une quelconque des revendications 1 à 10 sur une charpente du toit, **caractérisé en ce que** ledit procédé comprend les étapes suivantes :
a. fixer au moins un profilé longitudinal en forme de goulotte (20) entre deux éléments horizontaux (11) adjacents de la charpente du toit, qui sont disposés à certains intervalles les uns des autres, parallèlement au faîte du toit,
b. fixer au moins un profilé latéral longitudinal (30) à un bord latéral de la charpente du toit s'étendant perpendiculairement au faîte du toit,
c. poser des câbles électriques dans le au moins un profilé longitudinal en forme de goulotte (20),
d. raccorder le boîtier de raccordement électrique (60) par des câbles électriques (61) au module photovoltaïque (50) afin d'établir une connexion conductrice,
e. disposer les panneaux de toiture modulaires (40) de manière à former la couverture de toit, **dans lequel** les panneaux de toiture modulaires (40) comprenant le module photovoltaïque (50) intégré et le boîtier de raccordement électrique (60) sont disposés de telle sorte que le boîtier de raccordement électrique (60) soit suspendu dans un espace constituant une goulotte du au moins un profilé longitudinal en forme de goulotte (20).

18. Procédé selon la revendication 11, **dans lequel** il comprend l'étape consistant à remplir entièrement le jeu entre le bord de l'ouverture traversante (44) et le boîtier de raccordement électrique (60) avec un matériau électriquement isolant.
